# EUROPEAN PATENT APPLICATION

(11) **EP 4 726 784 A1**
(43) Date of publication of application: **15.04.2026**
(21) Application number: 24823239.9
(22) Date of filing: 30.05.2024
(51) Int. Cl.: H01L 33/38, H01L 33/10, H01L 33/22, H01L 33/42

(54) **METHOD FOR MANUFACTURING LIGHT EMITTING ELEMENT, AND LIGHT EMITTING ELEMENT**

(30) Priority: 12.06.2023 JP 2023096360
(71) Applicant: Nichia Corporation, Anan-shi, Tokushima 774-8601 (JP)
(72) Inventor: YAMAMOTO, Ryota, Anan-shi, Tokushima 774-8601 (JP)
(74) Representative: Betten & Resch
(86) International application number: PCT/JP2024/019848
(87) International publication number: WO 2024/257619

(57) **Abstract**

To provide a method for manufacturing a light-emitting element that can enhance brightness, and the light-emitting element. A method for manufacturing a light-emitting element includes: a step of preparing a wafer including a first insulating film disposed on a second semiconductor layer of a semiconductor structure, a first electrode disposed on the first insulating film, and a second electrode disposed on the first insulating film and connecting to the second semiconductor layer in an opening of the first insulating film; a step of removing a portion of the semiconductor structure from an upper surface side of a first semiconductor layer to separate the semiconductor structure into a plurality of light-emitting portions in such a manner that the first electrode includes a first portion located outward of an outer edge of each of the light-emitting portions in a plan view; a step of exposing the first portion of each of the first electrodes from the first insulating film and exposing a portion of the first semiconductor layer of each of the light-emitting portions from the second insulating film, wherein the exposing of the first portion of each of the first electrodes from the first insulating film is performed by removing a portion of the first insulating film; and a step of forming a first wiring on the second insulating film with respect to each of the light-emitting portions, the first wiring electrically connecting the portion of the first semiconductor layer exposed from the second insulating film and the first portion of the first electrode exposed from the first insulating film.

## Description

### Technical Field

The present invention relates to a method for manufacturing a light-emitting element and a light-emitting element.

### Background Art

Patent Document 1 discloses a light-emitting element including a first electrode disposed on a main light extraction surface of a light-emitting layer, and a second electrode disposed on a surface of the light-emitting layer opposite to the main light extraction surface.

### Citation List

### Patent Literature

Patent Document 1: JP 2015-32809 A

### Summary of Invention

### Technical Problem

An object of the present invention is to provide a method for manufacturing a light-emitting element in which the brightness is improved, and the light-emitting element.

### Solution to Problem

A method for manufacturing a light-emitting element according to an aspect of the present invention includes:
a step of preparing a wafer including: a first substrate; a semiconductor structure disposed on the first substrate and including a first semiconductor layer, a second semiconductor layer farther from the first substrate than the first semiconductor layer, and an active layer located between the first semiconductor layer and the second semiconductor layer; a first insulating film disposed on the second semiconductor layer and having an opening located above the second semiconductor layer; a plurality of first electrodes disposed on the first insulating film; and a plurality of second electrodes spaced apart from the first electrodes on the first insulating film, and electrically connected to the second semiconductor layer in the opening;
a step of bonding a side of the wafer where the second electrodes and the first electrodes are disposed to a second substrate;
a step of exposing an upper surface of the first semiconductor layer removing the first substrate after the bonding of the wafer to the second substrate;
a step of removing a portion of the semiconductor structure from a upper surface side of the first semiconductor layer to separate the semiconductor structure into a plurality of light-emitting portions in such a manner that the first electrode includes a first portion located outward of an outer edge of each of the light-emitting portions in a plan view;
a step of forming a second insulating film covering the light-emitting portions;
a step of exposing the first portion of each of the first electrodes from the first insulating film and exposing a portion of the first semiconductor layer of each of the light-emitting portions from the second insulating film, wherein the exposing of the first portion of each of the first electrodes from the first insulating film is performed by removing a portion of the first insulating film, and the exposing of the portion of the first semiconductor layer of each of the light-emitting portions from the second insulating film by removing the portion of the second insulating film ;
a step of forming a first wiring on the second insulating film with respect to each of the light-emitting portions, the first wiring electrically connecting the portion of the first semiconductor layer exposed from the second insulating film and the first portion of the first electrode exposed from the first insulating film; and
a step of separating the light-emitting portions and the second substrate after the first wiring is formed.

A light-emitting element according to an aspect of the present invention includes:
a semiconductor structure having a first surface, a second surface located opposite the first surface, and a lateral surface connecting the first surface and the second surface, the semiconductor structure including a first semiconductor layer located closer to the first surface, a second semiconductor layer located closer to the second surface, and an active layer located between the first semiconductor layer and the second semiconductor layer;
a first insulating film disposed on the second surface and having an opening disposed at a position overlapping the second surface in a plan view;
a first electrode disposed on the first insulating film and not connecting to the second surface, the first electrode including a first portion located outward of an outer edge of the semiconductor structure in the plan view;
a second electrode spaced apart from the first electrode on the first insulating film, and
electrically connected to the second semiconductor layer in the opening on the second surface;
a second insulating film disposed on the first surface and the lateral surface of the semiconductor structure; and
a first wiring disposed on the second insulating film, and electrically connecting a portion of the first semiconductor layer exposed from the second insulating film and the first portion of the first electrode exposed from the first insulating film.

### Advantageous Effects of Invention

An object of the present invention is to provide a method for manufacturing a light-emitting element in which the brightness is improved, and the light-emitting element.

### Brief Description of Drawings

FIG. 1A is a schematic top view of a light-emitting element according to a first embodiment.
FIG. 1B is a schematic bottom view of a light-emitting element according to a first embodiment.
FIG. 2 is a schematic cross-sectional view taken along the line II-II in FIG. 1.
FIG. 3 is a schematic cross-sectional view for illustrating a step of a method for manufacturing a light-emitting element according to the first embodiment.
FIG. 4 is a schematic cross-sectional view for illustrating a step of the method for manufacturing a light-emitting element according to the first embodiment.
FIG. 5 is a schematic cross-sectional view for illustrating a step of the method for manufacturing a light-emitting element according to the first embodiment.
FIG. 6 is a schematic cross-sectional view for illustrating a step of the method for manufacturing a light-emitting element according to the first embodiment.
FIG. 7 is a schematic cross-sectional view for illustrating a step of the method for manufacturing a light-emitting element according to the first embodiment.
FIG. 8 is a schematic cross-sectional view for illustrating a step of the method for manufacturing a light-emitting element according to the first embodiment.
FIG. 9 is a schematic cross-sectional view for illustrating a step of the method for manufacturing a light-emitting element according to the first embodiment.
FIG. 10 is a schematic top view for illustrating a step of the method for manufacturing a light-emitting element according to the first embodiment.
FIG. 11 is a schematic cross-sectional view for illustrating a step of the method for manufacturing a light-emitting element according to the first embodiment.
FIG. 12 is a schematic cross-sectional view for illustrating a step of the method for manufacturing a light-emitting element according to the first embodiment.
FIG. 13 is a schematic cross-sectional view for illustrating a step of the method for manufacturing a light-emitting element according to the first embodiment.
FIG. 14 is a schematic cross-sectional view for illustrating a step of the method for manufacturing a light-emitting element according to the first embodiment.
FIG. 15 is a schematic cross-sectional view for illustrating a step of the method for manufacturing a light-emitting element according to the first embodiment.
FIG. 16 is a schematic cross-sectional view for illustrating a step of the method for manufacturing a light-emitting element according to the first embodiment.
FIG. 17 is a schematic cross-sectional view for illustrating a step of the method for manufacturing a light-emitting element according to the first embodiment.
FIG. 18 is a schematic cross-sectional view of a light-emitting element according to a second embodiment.
FIG. 19 is a schematic cross-sectional view for illustrating a step of a method for manufacturing a light-emitting element according to the second embodiment.
FIG. 20 is a schematic cross-sectional view for illustrating a step of the method for manufacturing a light-emitting element according to the second embodiment.
FIG. 21A is a schematic bottom view of a light-emitting element according to a third embodiment.
FIG. 21B is a schematic cross-sectional view taken along the line XXIB-XXIB of FIG. 21A.
FIG. 22 is a schematic cross-sectional view for illustrating a step of a method for manufacturing a light-emitting element according to the third embodiment.
FIG. 23 is a schematic cross-sectional view for illustrating a step of the method for manufacturing a light-emitting element according to the third embodiment.
FIG. 24 is a schematic cross-sectional view for illustrating a step of the method for manufacturing a light-emitting element according to the third embodiment.
FIG. 25 is a schematic cross-sectional view for illustrating a step of the method for manufacturing a light-emitting element according to the third embodiment.

### Description of Embodiments

Embodiments are described below with reference to the drawings. Dimensions, materials, shapes, relative arrangements, or the like of constituent members described in the embodiments are not intended to be limited to the scope of the present disclosure, unless otherwise specified, and are merely exemplary. Note that the sizes, positional relationship, or the like of members illustrated in each of the drawings may be exaggerated for clarity of description. Furthermore, in the following description, members having the same names and reference signs represent the same or similar members, and detailed description of these members is omitted as appropriate. As a cross-sectional view, an end view illustrating only a cut surface may be illustrated. In the cross-sectional view, hatching is not applied to the cross-section of a semiconductor structure in order to make it easy to see the boundary of each layer of the semiconductor structure.

In the following description, terms indicating specific directions or positions (for example, "upper", "above", "lower" "below", and other terms including those terms) may be used. However, these terms are used merely to make it easy to understand relative directions or positions in the referenced drawing. As long as the relative direction or relative position is the same as that described in the referenced drawing using the term such as "upper" "above" or "lower" "below", in drawings other than the drawings of the present disclosure, actual products, and the like, components does not have to be arranged in the same manner as that in the referenced drawing. For example, on the assumption that there are two members, the positional relationship expressed as "on" "upper/above (or lower/below" in the present specification may include a case in which the two members are in contact with each other and a case in which the two members are not in contact with each other and one of the two members is located above (or below) the other member. Further, in the present specification, unless otherwise specified, a case in which a member covers an object to be covered includes a case in which the member is in contact with the object and directly covers the object, and a case in which the member is not in contact with the object and indirectly covers the object.

### First Embodiment

### Light-Emitting Element

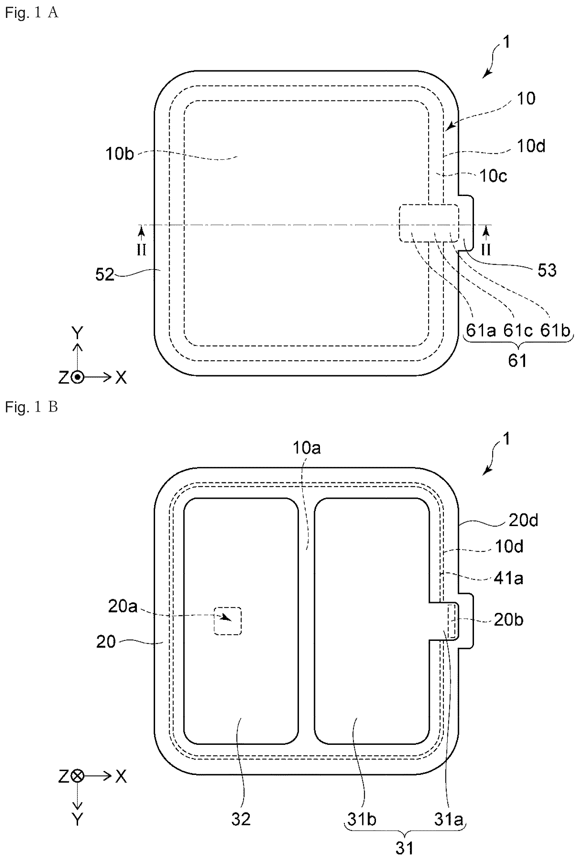

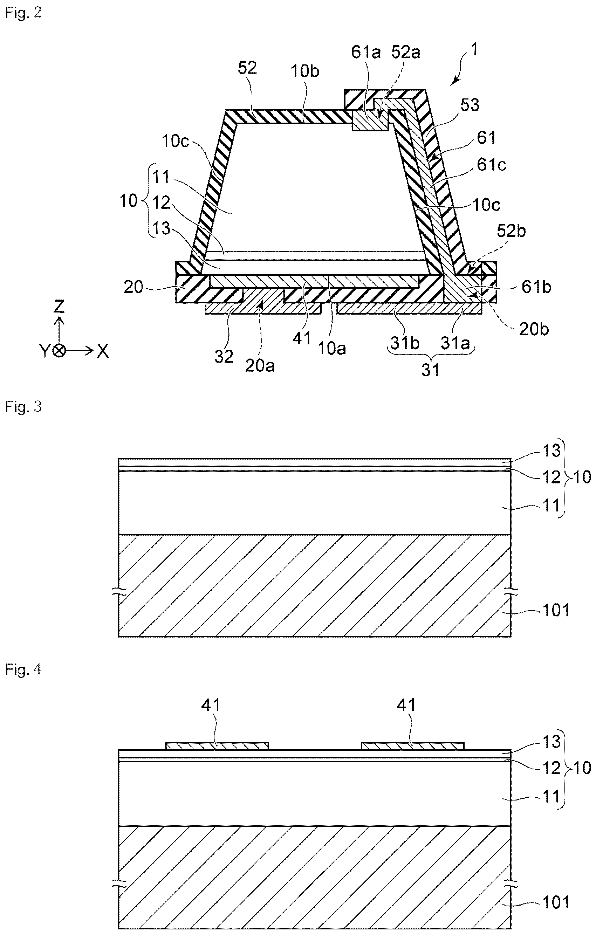

A light-emitting element 1 according to the first embodiment will be described with reference to FIGS. 1A, 1B, and 2. In a top view of the light-emitting element 1 illustrated in FIG. 1A, and in a bottom view of the light-emitting element 1 illustrated in FIG. 1B, two directions orthogonal to each other are referred to as a first direction X and a second direction Y. A direction orthogonal to the first direction X and the second direction Y is referred to as a third direction Z. FIG. 2 is a schematic cross-sectional view taken along the line II-II in FIG. 1.

The light-emitting element 1 includes a semiconductor structure 10, a first insulating film 20, a first electrode 31, a second electrode 32, a second insulating film 52, and a first wiring 61.

### Semiconductor Structure

The semiconductor structure 10 includes a first surface 10b, a second surface 10a located opposite the first surface 10b in the third direction Z, and a lateral surface 10c connecting the first surface 10b and the second surface 10a. The semiconductor structure 10 includes a first semiconductor layer 11 located closer to the first surface 10b, a second semiconductor layer 13 located closer to the second surface 10a, and an active layer 12 located between the first semiconductor layer 11 and the second semiconductor layer 13. The active layer 12 is a light-emitting layer that emits light and has a multiple quantum well (MQW) structure including a plurality of barrier layers and a plurality of well layers, for example. The active layer 12 emits light having a light emission peak wavelength in a range of 210 nm to 580 nm, for example. For example, the first semiconductor layer 11 is a semiconductor layer including n-type impurities, and the second semiconductor layer 13 is a semiconductor layer including p-type impurities. Light emitted by the active layer 12 exits mainly from the first surface 10b and the lateral surface 10c to the outside of the semiconductor structure 10.

On the second surface 10a side, the first semiconductor layer 11 does not include a portion that is exposed from the second semiconductor layer 13 and the active layer 12. The active layer 12 is in contact with the entire surface of the first semiconductor layer 11 located opposite the first surface 10b. This configuration can increase the area of the active layer 12 in a plan view, and enhance the brightness of the light-emitting element 1 compared with a configuration in which the first semiconductor layer 11 has an opening on the second surface 10a side, through which a portion of the first semiconductor layer 11 is exposed from the second semiconductor layer 13 and the active layer 12.

The first surface 10b is a surface of the first semiconductor layer 11 located opposite the active layer 12. The second surface 10a is a surface of the second semiconductor layer 13 located opposite the active layer 12. The lateral surface 10c of the semiconductor structure 10 includes a lateral surface of the first semiconductor layer 11, a lateral surface of the active layer 12, and a lateral surface of the second semiconductor layer 13. In a plan view, an area of the second surface 10a is greater than the area of the first surface 10b. The active layer 12 is located closer to the second surface 10a than to the first surface 10b. Thus, because the area of the second surface 10a is greater than the area of the first surface 10b in a plan view, the area of the active layer 12 in a plan view can be increased as compared with a case in which the area of the first surface 10b is greater than the area of the second surface 10a in a plan view. In the example illustrated in FIG. 2, the lateral surface 10c is inclined with respect to the first surface 10b and the second surface 10a such that the first surface 10b and the lateral surface 10c form an obtuse angle, and the second surface 10a and the lateral surface 10c form an acute angle in a cross-sectional view.

In a plan view of the light-emitting element 1 (the top view illustrated in FIG. 1A or the bottom view illustrated in FIG. 1B), the shape of an outer edge 10d of the semiconductor structure 10 is, for example, a quadrangular shape. The outer edge 10d is the outer edge of the second surface 10a. For example, the length of one side of the outer edge 10d is in a range of 5 µm to 150 µm. For example, the corners of the outer edge 10d can be rounded, and in that case, the length of one side of the outer edge 10d refers to the length of the straight portion of one side of the outer edge 10d.

The semiconductor structure 10 is formed of a nitride semiconductor. In the present specification, for example, it is assumed that the "nitride semiconductor" includes semiconductors having all compositions in which the composition ratios x and y are changed within the respective ranges in a chemical formula of InₓAl_{y}Ga_{1-x-y}N (0 ≤ x ≤ 1, 0 ≤ y ≤ 1, x + y ≤ 1). It is assumed that the "nitride semiconductor" includes, in its category, a semiconductor further containing a group V element other than nitrogen (N) in the above chemical formula, and a semiconductor further containing, in the above chemical formula, any of various elements added to control any of various physical properties such as a conductivity type.

### First Insulating Film

The first insulating film 20 is disposed on the second surface 10a of the semiconductor structure 10, and covers the second surface 10a. As illustrated in FIG. 1B, the first insulating film 20 has a first opening 20a disposed at a position overlapping the second surface 10a of the semiconductor structure 10 in a plan view. In the example illustrated in FIG. 1B, the first insulating film 20 has one first opening 20a, but the first insulating film 20 may have a plurality of first openings 20a. In a plan view, an outer edge 20d of the first insulating film 20 is located outward of the outer edge 10d of the semiconductor structure 10. The first insulating film 20 includes a second opening 20b at a position located outward of the outer edge 10d of the semiconductor structure 10.

For example, a silicon oxide film or a silicon nitride film can be used as the first insulating film 20. Also, the first insulating film 20 can include a dielectric multilayer film. In this case, the light traveling from the active layer 12 toward the second surface 10a can be reflected by the dielectric multilayer film, and directed toward the first surface 10b and the lateral surface 10c. This configuration can enhance the brightness of the light-emitting element 1. The reflectance of the dielectric multilayer film to the peak wavelength of light emitted from the active layer 12 is, for example, 60% or greater and preferably 70% or greater. The first insulating film 20, as a dielectric multilayer film, can include, for example, SiO₂ layers and Nb₂O₅ layers that are alternately layered. For example, where a Nb₂O₅ layer with a thickness in a range of 10 nm to 100 nm, and a SiO₂ layer with a thickness in a range of 10 nm to 100 nm are paired, the dielectric multilayer film can be formed of two or more and six or less pairs of these layers. Setting the film thickness and the number of pairs of layers of the dielectric multilayer film in this manner makes it possible to obtain satisfactory light reflectivity.

### First Electrode

As illustrated in FIG. 2, the first electrode 31 is disposed on the first insulating film 20. The first electrode 31 is not connected to the second surface 10a of the semiconductor structure 10. The first insulating film 20 is positioned between the first electrode 31 and the second surface 10a. As illustrated in FIG. 1B, the first electrode 31 includes a first portion 31a located outward of the outer edge 10d of the semiconductor structure 10 in a plan view. As described below, the first electrode 31 is electrically connected to the first semiconductor layer 11 via the first wiring 61.

The first electrode 31 may be a metal layer of a single layer containing, for example, Ti, Rh, Au, Pt, Al, Ag, Rh, or Ru, or a layered structure including at least two of these metal layers.

### Second Electrode

The second electrode 32 is disposed on the first insulating film 20. As illustrated in FIG. 1B, the second electrode 32 is separated from the first electrode 31. As illustrated in FIG. 2, a portion of the second electrode 32 is disposed in the first opening 20a of the first insulating film 20. The second electrode 32 is electrically connected to the second semiconductor layer 13 in the first opening 20a in the second surface 10a of the semiconductor structure 10. FIG. 2 illustrates an example in which the second electrode 32 is electrically connected to the second semiconductor layer 13 via a conductive layer 41 described later. Alternatively, the second electrode 32 may be electrically connected to the second semiconductor layer 13 by direct contact in the first opening 20a.

The second electrode 32 may be a single layer of a metal layer containing the same material as the first electrode 31, or a layered structure including at least two of these metal layers.

### Second Insulating Film

The second insulating film 52 is disposed on the first surface 10b and the lateral surface 10c of the semiconductor structure 10. The second insulating film 52 covers the first surface 10b and the lateral surface 10c. The second insulating film 52 is disposed on a portion of the first insulating film 20, which is located outward of the outer edge 10d of the semiconductor structure 10 in a plan view. The transmittance of the second insulating film 52 to the peak wavelength of light emitted from the active layer 12 is, for example, 60% or greater and preferably 70% or greater. For example, a silicon oxide film or a silicon nitride film can be used as the second insulating film 52.

The second insulating film 52 has a third opening 52a located above the first surface 10b of the semiconductor structure 10. The third opening 52a may be located on the lateral surface 10c of the semiconductor structure 10. The second insulating film 52 has a fourth opening 52b located above the second opening 20b of the first insulating film 20.

### First Wiring

The first wiring 61 is disposed on the second insulating film 52, and electrically connects a portion of the first semiconductor layer 11 exposed from the second insulating film 52 at the third opening 52a, and the first portion 31a of the first electrode 31 exposed from the first insulating film 20 at the second opening 20b.

The first wiring 61 includes a first connecting portion 61a disposed in the third opening 52a of the second insulating film 52, and electrically connected to the first semiconductor layer 11 on the first surface 10b. When the third opening 52a is located on the lateral surface 10c of the semiconductor structure 10, the first wiring 61 is electrically connected to the first semiconductor layer 11 on the lateral surface 10c. The first wiring 61 includes a second connecting portion 61b disposed in the second opening 20b of the first insulating film 20, and electrically connected to the first portion 31a of the first electrode 31. The first wiring 61 includes an intermediate portion 61c connecting the first connecting portion 61a and the second connecting portion 61b, and located on the second insulating film 52 covering the lateral surface 10c of the semiconductor structure 10. The lower end portion of the intermediate portion 61c is disposed in the fourth opening 52b of the second insulating film 52, and is connected to the second connecting portion 61b. The intermediate portion 61c is in contact with the second insulating film 52. The first wiring 61 is formed of a light-transmissive conductive film or a metal film.

The light-emitting element 1 can be disposed on a wiring substrate with the second surface 10a of the semiconductor structure 10 facing the wiring substrate. The first electrode 31 and the second electrode 32 disposed on the second surface 10a side can be electrically connected to a conductive portion of the wiring substrate via a connection member such as solder, for example. The second electrode 32 is electrically connected to the second semiconductor layer 13 through the first opening 20a of the first insulating film 20 on the second surface 10a side. In contrast, the first electrode 31 is not electrically connected to the first semiconductor layer 11 on the second surface 10a side, but is electrically connected to the first semiconductor layer 11 on the first surface 10b side via the first wiring 61. Thus, because the semiconductor structure 10 is electrically connected to the first electrode 31 and the second electrode 32 without removing the active layer 12, a large area of the active layer 12 in a plan view can be ensured, and the brightness of the light-emitting element 1 can be enhanced.

As a configuration example for reference, the configuration in which the first semiconductor layer 11 is electrically connected to the conductive portion of the wiring substrate, a configuration in which the first surface 10b and the conductive portion of the wiring substrate are connected by a wire can be considered. According to the present embodiment, the first semiconductor layer 11 is electrically connected to the conductive portion of the wiring substrate via the first wiring 61 disposed on the second insulating film 52 covering the lateral surface 10c of the semiconductor structure 10, and the first electrode 31 disposed on the second surface 10a side. The configuration of the present embodiment can reduce the area of the region for disposing and connecting the light-emitting element on and to the wiring substrate as compared to the example for reference. This can allow for size reduction in the light-emitting device including the light-emitting element and the wiring substrate. In addition, it is easier to dispose a plurality of light-emitting elements on the wiring substrate at high density.

As described above, the light emitted from the active layer 12 exits from the first surface 10b and the lateral surface 10c of the semiconductor structure 10. Thus, as illustrated in FIG. 1A, in a plan view, the width of the first wiring 61 in the second direction Y is preferably less than the width of the first surface 10b in the second direction Y and the width of the lateral surface 10c in the second direction Y. This can reduce absorption, by the first wiring 61,of the light emitted from the active layer 12, thereby enhancing the brightness of the light-emitting element 1.

The area of the first connecting portion 61a in a plan view is preferably in a range of 1% to 20% of the area of the first surface 10b. The first connecting portion 61a having the area as described above can reduce absorption, by the first wiring 61, of the light emitted from the active layer 12. The width of the intermediate portion 61c in the second direction Y is preferably less than the width of the first connecting portion 61a in the second direction Y. This can reduce the absorption, by the intermediate portion 61c, of the light emitted from the active layer 12. When the width of the intermediate portion 61c in the second direction Y is less than the width of the first connecting portion 61a in the second direction Y, the width of the intermediate portion 61c in the second direction Y is in a range of 5% to 50% of the width of the first connecting portion 61a in the second direction Y. The first wiring 61 is preferably formed of a light-transmissive conductive film. This can reduce absorption, by the first wiring 61, of the light emitted from the active layer 12, and enhance the brightness of the light-emitting element 1. As a material of the light-transmissive conductive film of the first wiring 61, indium tin oxide (ITO), zinc oxide (ZnO), or indium oxide (In₂O₃) can be used, for example. Reflectance of the light-transmissive conductive film to a light emission peak wavelength of light emitted from the active layer 12 is, for example, 60% or greater and preferably 70% or greater. In addition, the light-transmissive conductive film using these materials can reduce the contact resistance with the semiconductor structure 10 on the first surface 10b compared to a case in which a metal film is used.

In a case in which the first electrode 31 is connected to the first semiconductor layer 11 on the second surface 10a side, in a plan view, the ratio of the area of the first semiconductor layer 11 exposed from the second semiconductor layer 13 and the active layer 12 to the total area of the second surface 10a tends to increase as the size of the light-emitting element 1 decreases. Thus, the configuration of the present embodiment in which the active layer 12 is not removed is more effective in ensuring a large area of the active layer 12 in a plan view, and easily enhances the brightness, for example, in the case in which the length of one side of the light-emitting element 1 in a plan view is 100 µm or less.

As illustrated in FIG. 1B, the first electrode 31 further includes a second portion 31b located inward of the outer edge 10d of the semiconductor structure 10 in a plan view. The second portion 31b and the first portion 31a can be monolithically formed of the same material. The first electrode 31 includes the second portion 31b located inward of the outer edge 10d of the semiconductor structure 10 in a plan view, so that the area of the first electrode 31 can be increased while the size of the light-emitting element 1 is reduced in a plan view. The area of the first electrode 31 in a plan view is increased, so that the contact area between the first electrode 31 and the conductive portion of the wiring substrate can be increased, and the forward voltage of the light-emitting element 1 can be reduced. In addition, heat that is generated by the semiconductor structure 10 can be easily dissipated to the wiring substrate via the second portion 31b. The second portion 31b overlaps the second surface 10a of the semiconductor structure 10 in a plan view.

In a plan view, the area of the first electrode 31 including the first portion 31a and the second portion 31b can be, for example, in a range of 80% to 120% of the area of the second electrode 32. This configuration can reduce the difference in area between the first electrode 31 and the second electrode 32 in a plan view, and can reduce misalignment that is caused when the light-emitting element 1 is disposed on the wiring substrate via a connection member such as solder.

In a plan view, the area of the first portion 31a located outside the outer edge 10d of the semiconductor structure 10 is preferably less than the area of the second portion 31b. Accordingly, the size of the light-emitting element 1 can be reduced. In addition, the area of the second portion 31b is greater than the area of the first portion 31a in a plan view, so that the ease of disposing the light-emitting element 1 on the wiring substrate, the effect of reducing the forward voltage, and the heat dissipation effect, which have been described above, can be enhanced. In a plan view, the area of the first portion 31a is in a range of 5% to 20% of the area of the second portion 32b, for example.

In a plan view, the sum of the area of the second portion 31b and the area of the second electrode 32 is preferably in a range of 60% to 90% of the area of the second surface 10a. The value is set as described above, so that a portion of the light from the active layer 12, which travels toward the second surface 10a, can be easily reflected by the second portion 31b and the second electrode 32, and thus the light extraction efficiency can be enhanced.

### Conductive Layer

As illustrated in FIG. 2, the light-emitting element 1 may further include the conductive layer 41 disposed on the second surface 10a of the semiconductor structure 10. The conductive layer 41 is electrically connected to the second semiconductor layer 13 on the second surface 10a. The conductive layer 41 is covered with the first insulating film 20. A portion of the conductive layer 41 is exposed from the first insulating film 20 at the first opening 20a, and is electrically connected to the second electrode 32.

As illustrated in FIG. 1B, the outer edge 41a of the conductive layer 41 is located inward of the outer edge 10d of the semiconductor structure 10 in a plan view. In a plan view, the area of the conductive layer 41 is greater than the area of the first opening 20a. Compared to a case in which the second electrode 32 is directly connected to the second surface 10a through the first opening 20a, a current supplied through the second electrode 32 is easily diffused in the planar direction of the second semiconductor layer 13 by the conductive layer 41.

As the material of the conductive layer 41, a light-transmissive conductive film can be used, for example. Examples of the light-transmissive conductive film include light-transmissive conductive films of ITO, ZnO, or In₂O₃. The use of these materials can reduce the contact resistance between the conductive layer 41 and the second surface 10a, and reduce the forward voltage of the light-emitting element 1 compared to a case in which a metal material is used. A metal material may be used as the material of the conductive layer 41. Examples of the metal material of the conductive layer 41 include materials the same as or similar to the materials used for the first electrode 31. Using these materials can allow light from the active layer 12 to be more easily reflected, and thus can enhance the light extraction efficiency in the light-emitting element 1 compared to a case in which a light-transmissive conductive film is used.

### Third Insulating Film

The light-emitting element 1 can further include a third insulating film 53. The third insulating film 53 covers the first wiring 61. For example, a silicon oxide film or a silicon nitride film can be used as the third insulating film 53.

Method for Manufacturing Light-emitting Element A method for manufacturing a light-emitting element according to the first embodiment will now be described with reference to FIGS. 3 to 17. The method for manufacturing a light-emitting element according to the first embodiment includes: preparing a wafer; bonding the wafer to a second substrate; exposing an upper surface of a first semiconductor layer; separating a semiconductor structure into a plurality of light-emitting portions; forming a second insulating film; exposing a first portion of a first electrode from a first insulating film, and exposing a portion of the first semiconductor layer from the second insulating film; forming a first wiring; and separating the light-emitting portions and the second substrate.

### Step of Preparing Wafer

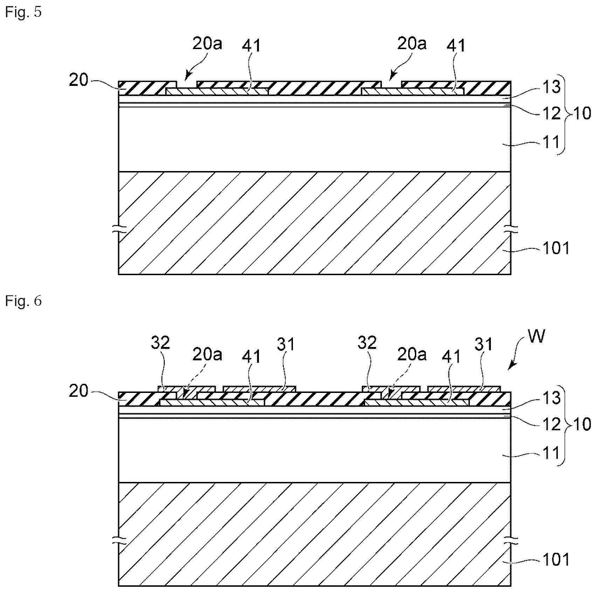

FIG. 6 illustrates a portion of a wafer W. The wafer W includes a first substrate 101, the semiconductor structure 10, the first insulating film 20, the first electrodes 31, and the second electrodes 32.

For example, an insulating substrate such as sapphire or spinel (MgAl₂O₄) having any of a C-plane, an R-plane, and an A-plane as a primary surface may be used as the first substrate 101. Further, a conductive substrate of SiC (including 6H, 4H, and 3C), ZnS, ZnO, GaAs, Si, or the like may be used as the first substrate 101. In the present embodiment, a sapphire substrate having a C-plane as a primary surface is used as the first substrate 101. The semiconductor structure 10 is disposed on the primary surface of the first substrate 101. The semiconductor structure 10 includes the first semiconductor layer 11, the second semiconductor layer 13 farther from the first substrate 101 than the first semiconductor layer, and the active layer 12 located between the first semiconductor layer 11 and the second semiconductor layer 13.

The surface of the first semiconductor layer 11 located on the side of the active layer 12 does not include a portion exposed from the second semiconductor layer 13 and the active layer 12. This can increase the area of the active layer 12 in a plan view as described above.

In addition, it is preferable that a portion of the first semiconductor layer 11 is not exposed from the second semiconductor layer 13 and the active layer 12 on the upper surface side of the semiconductor structure 10 where the second semiconductor layer 13 is located. Thus, in the case in which there is a process using liquid, such as wet etching, in the subsequent steps, the metal included in the first electrode 31 or the second electrode 32 is ionized in the liquid, and the occurrence of migration of the metal due to the potential difference between the portion (the exposed portion) of the first semiconductor layer 11 and the second semiconductor layer 13 can be reduced. Thus, the metal is less likely to be deposited on an unintended portion, and the reliability of the light-emitting element can be enhanced.

The first insulating film 20 is located on the second semiconductor layer 13, and includes the first opening 20a located above the second semiconductor layer 13. The first electrode 31 is disposed on the first insulating film 20. The second electrode 32 is disposed on the first insulating film 20 and spaced apart from the first electrode 31, and is electrically connected to the second semiconductor layer 13 in the first opening 20a. The wafer W may further include the conductive layer 41 disposed on the second semiconductor layer 13 and electrically connected to the second electrode 32.

In the step of preparing the wafer W, the wafer W illustrated in FIG. 6 can be purchased and prepared.

The step of preparing the wafer W may include the steps illustrated in FIGS. 3 to 6. Each step illustrated in FIGS. 3 to 6 will be described below.

In the step illustrated in FIG. 3, the semiconductor structure 10 is formed on the first substrate 101. For example, the first semiconductor layer 11, the active layer 12, and the second semiconductor layer 13 are formed in this order on the first substrate 101 by a metal organic chemical vapor deposition (MOCVD) method to form the semiconductor structure 10. In the present embodiment, after the semiconductor structure 10 is formed on the first substrate 101, a step of removing a portion of the second semiconductor layer 13 and a portion of the active layer 12, and exposing a portion of the first semiconductor layer 11 from the second semiconductor layer 13 and the active layer 12 is not performed.

As illustrated in FIG. 4, the step of preparing the wafer W may include a step of forming the conductive layer 41 on the second semiconductor layer 13. The conductive layer 41 is in contact with the upper surface of the second semiconductor layer 13, and electrically connected to the second semiconductor layer 13. The conductive layer 41 can be formed by a sputtering method or a vapor deposition method, for example. The conductive layer 41 does not have to be formed. In the following description, a case in which the conductive layer 41 is formed will be described.

As illustrated in FIG. 5, the step of preparing the wafer W includes a step of forming the first insulating film 20 having the first opening 20a located above the conductive layer 41, the first insulating film 20 being formed on the second semiconductor layer 13 and on the conductive layer 41. A portion of the conductive layer 41 is exposed from the first insulating film 20 at the first opening 20a. The first insulating film 20 can be formed by a chemical vapor deposition (CVD) method or the sputtering method, for example. The first opening 20a can be formed by, for example, removing a portion of the first insulating film 20 by etching.

The step of preparing the wafer W includes a step of forming the first electrode 31 and the second electrode 32 as illustrated in FIG. 6. The second electrode 32 is formed on the first insulating film 20 and in the first opening 20a, and is electrically connected to the conductive layer 41 in the first opening 20a. The second electrode 32 is electrically connected to the second semiconductor layer 13 via the conductive layer 41. The first electrode 31 is formed on the first insulating film 20 and spaced apart from the second electrode 32. In the step illustrated in FIG. 6, the first electrode 31 is not electrically connected to the first semiconductor layer 11. The first electrode 31 and the second electrode 32 can be formed by the sputtering method or vapor deposition method, for example. The first electrode 31 and the second electrode 32 can be formed simultaneously using the same material.

### Step of Bonding Wafer to Second Substrate

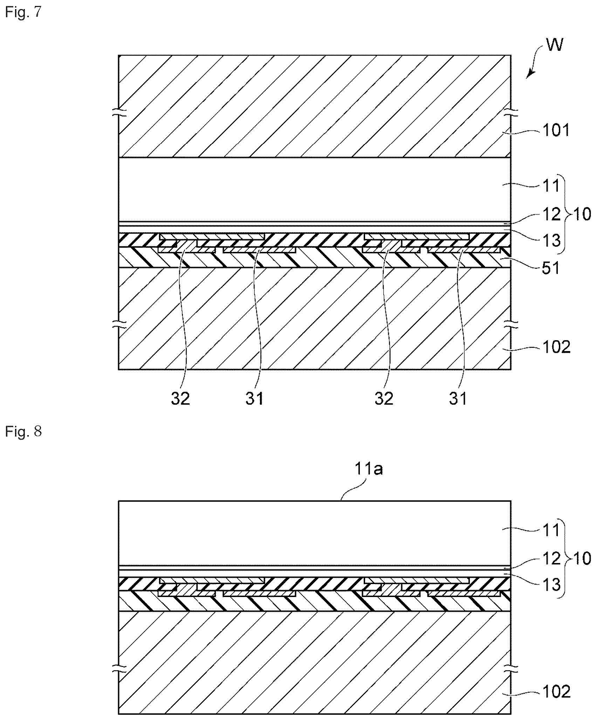

As illustrated in FIG. 7, the side of the wafer W where the second electrode 32 and the first electrode 31 are disposed is bonded to a second substrate 102 via a bonding member 51. The wafer W illustrated in FIG. 7 is in a vertically upside-down position relative to the wafer W illustrated in FIG. 6.

The bonding member 51 is disposed between the first insulating film 20 and the second substrate 102. The bonding member 51 covers the first electrode 31 and the second electrode 32. As the bonding member 51, for example, a resin member formed mainly from an epoxy resin, an acrylic resin, or a polyimide resin can be used. The second substrate 102 can use a substrate the same as or similar to that used for the first substrate 101, for example.

### Step of Exposing Upper Surface of First Semiconductor Layer

After the step of bonding together the wafer W and the second substrate 102, as illustrated in FIG. 8, the first substrate 101 is removed to expose an upper surface 11a of the first semiconductor layer 11. The first substrate 101 can be removed by, for example, a laser lift off (LLO) method, grinding, polishing, or etching.

### Step of Separating Semiconductor Structure into Plurality of Light-emitting Portions

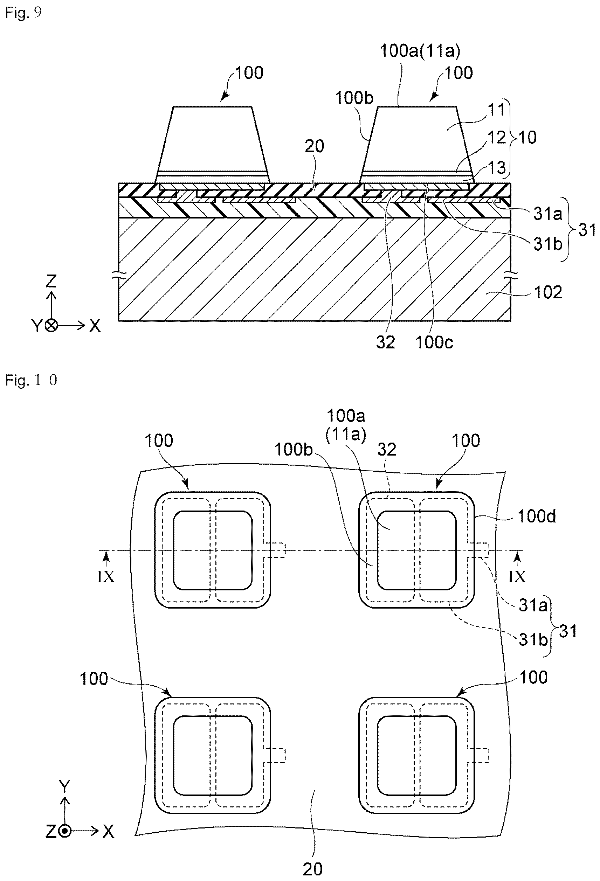

After the first substrate 101 is removed, a portion of the semiconductor structure 10 is removed from the upper surface 11a side of the exposed first semiconductor layer 11, and the semiconductor structure 10 is separated into a plurality of light-emitting portions 100 as illustrated in FIGS. 9 and 10. FIG. 9 is a schematic cross-sectional view taken along the line IX-IX in FIG. 10.

In the step of separating the semiconductor structure 10 into the plurality of light-emitting portions 100, as illustrated in FIG. 10, the semiconductor structure 10 is separated into the plurality of light-emitting portions 100 so that the first electrode 31 includes the first portion 31a located outward of an outer edge 100d of the light-emitting portion 100 in a plan view. That is, a potion of the semiconductor structure 10 overlapping a portion of the first electrode 31 (a portion corresponding to the first portion 31a) in a plan view is removed.

In the step of separating the semiconductor structure 10 into the plurality of light-emitting portions 100, the upper surface of the first insulating film 20 is exposed from the semiconductor structure 10 (light-emitting portion 100) by removing a portion of the semiconductor structure 10. A portion of the semiconductor structure 10 is removed, so that a groove extending in the first direction X and the second direction Y is formed on the first insulating film 20, and the semiconductor structure 10 is separated into the plurality of light-emitting portions 100 arranged in the first direction X and the second direction Y.

A portion of the semiconductor structure 10 can be removed by dry etching using a mask. Examples of the dry etching to be used include Reactive Ion Etching (RIE). In the RIE method, for example, a gas containing chlorine such as Cl₂ or SiCl₄ can be used. Because the etching amount is more easily controlled in dry etching than in wet etching, the light-emitting portion 100 can be formed into a desired shape by removing a portion of the semiconductor structure 10 by dry etching. Also, a portion of the semiconductor structure 10 can be removed by wet etching using a mask.

The light-emitting portion 100 has an upper surface 100a, a lower surface 100c located on the opposite side to the upper surface 100a in the third direction Z, and a lateral surface 100b connecting the upper surface 100a and the lower surface 100c. The upper surface 100a of the light-emitting portion 100 is the upper surface 11a of the first semiconductor layer 11. The lower surface 100c of the light-emitting portion 100 is the lower surface of the second semiconductor layer 13. The lateral surface 100b of the light-emitting portion 100 corresponds to the lateral surface 10c of the semiconductor structure 10 illustrated in FIG. 2. The area of the lower surface 100c of the light-emitting portion 100 is greater than the area of the upper surface 100a of the light-emitting portion 100. The lateral surface 100b of the light-emitting portion 100 includes the lateral surface of the first semiconductor layer 11, the lateral surface of the active layer 12, and the lateral surface of the second semiconductor layer 13.

As illustrated in FIG. 9, the cross-sectional shape of the light-emitting portion 100 can be substantially trapezoidal. The active layer 12 is located at a position closer to the lower surface 100c of the light-emitting portion 100 than to upper surface 100a. Also, the area of the lower surface 100c of the light-emitting portion 100 is greater than the area of the upper surface 100a of the light-emitting portion 100. Thus, the light-emitting portion 100 can be formed with a larger area of the active layer 12 compared to a case in which the area of the upper surface 100a is greater than the area of the lower surface 100c. The lateral surface 100b is inclined with respect to the upper surface 100a. An angle formed by the lateral surface 100b and the lower surface 100c is an acute angle, and an angle formed by the lateral surface 100b and the upper surface 100a is an obtuse angle.

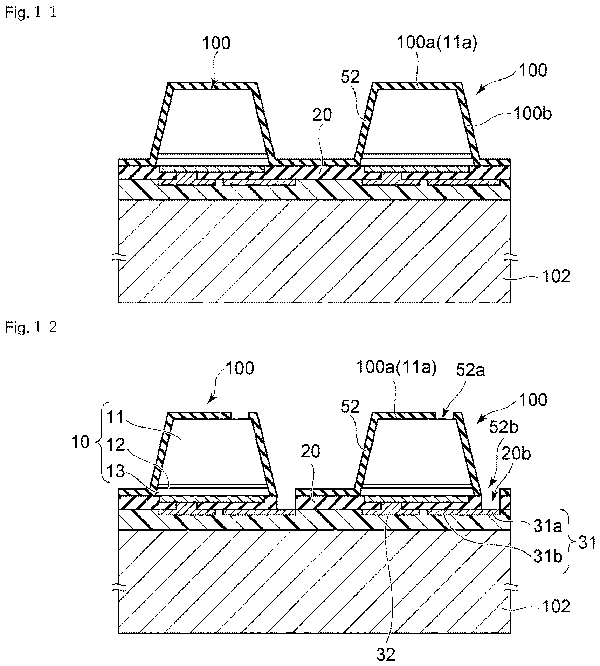

Step of Forming Second Insulating Film After the step of separating the semiconductor structure 10 into the plurality of light-emitting portions 100, the second insulating film 52 covering the light-emitting portions 100 is formed as illustrated in FIG. 11. The second insulating film 52 covers the upper surface 100a and the lateral surface 100b of the light-emitting portion 100. The second insulating film 52 covers the upper surface of the first insulating film 20 exposed from the light-emitting portions 100. The second insulating film 52 does not have to cover the upper surface of the first insulating film 20. The second insulating film 52 may be formed, for example, by the CVD method or sputtering method.

### Step of Exposing First Portion of First Electrode from First Insulating Film, and Exposing Portion of First Semiconductor Layer from Second Insulating Film

After the step of forming the second insulating film 52, as illustrated in FIG. 12, a portion of the first insulating film 20 is removed to expose the first portions 31a of the first electrodes 31 from the first insulating film 20, and a portion of the second insulating film 52 is removed to expose portions of the first semiconductor layer 11 of the light-emitting portions 100 from the second insulating film 52.

For example, a portion of the first insulating film 20 and a portion of the second insulating film 52 can be removed by the RIE method using a mask. As the gas used in the RIE method, a gas containing fluorine can be used, for example.

The third opening 52a is formed in the second insulating film 52 by removing a portion of the second insulating film 52 covering the upper surface 11a of the first semiconductor layer 11, which is the upper surface 100a of the light-emitting portion 100. In the third opening 52a, a portion of the upper surface 11a of the first semiconductor layer 11 is exposed from the second insulating film 52. In the second insulating film 52, the third opening 52a may be formed at a position where the lateral surface 10c is exposed.

The second opening 20b is formed in the first insulating film 20 by removing a portion of the first insulating film 20 positioned above the first portion 31a of the first electrode 31. In the second opening 20b, the first portion 31a of the first electrode 31 is exposed from the first insulating film 20.

In a case in which the second insulating film 52 covers the upper surface of the first insulating film 20, the fourth opening 52b is formed in the second insulating film 52 by removing a portion of the second insulating film 52 located above the first portion 31a of the first electrode 31 before forming the second opening 20b in the first insulating film 20. After the fourth opening 52b is formed in the second insulating film 52, a portion of the first insulating film 20 exposed from the second insulating film 52 in the fourth opening 52b is removed to form the second opening 20b below the fourth opening 52b. The first portion 31a of the first electrode 31 is exposed from the first insulating film 20 and the second insulating film 52 at the second opening 20b and the fourth opening 52b.

### Step of Forming First Wiring

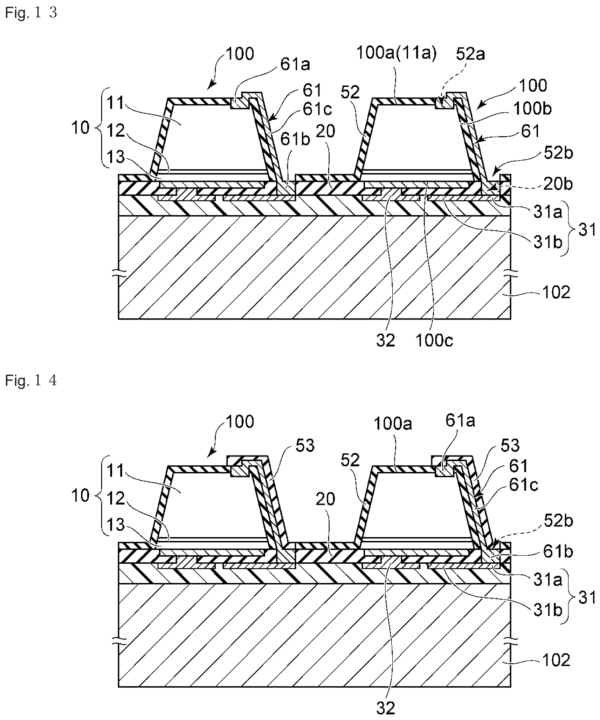

After the step of exposing the first portion 31a of the first electrode 31 from the first insulating film 20, and exposing the portion of the first semiconductor layer 11 from the second insulating film 52, the first wiring 61 is formed on the second insulating film 52 as illustrated in FIG. 13. The first wiring 61 can be formed by the sputtering method or vapor deposition method, for example.

The first wiring 61 electrically connects the first portion 31a of the first electrode 31 exposed from the first insulating film 20 to the portion of the first semiconductor layer 11 exposed from the second insulating film 52. This can allow the first electrode 31 disposed on the lower surface 100c side of the light-emitting portion 100 to be electrically connected to the first semiconductor layer 11 on the upper surface 11a side of the first semiconductor layer 11 without exposing a portion of the first semiconductor layer 11 from the second semiconductor layer 13 and the active layer 12 on the lower surface 100c side of the light-emitting portion 100.

The first connecting portion 61a of the first wiring 61 is electrically connected to the upper surface 11a of the first semiconductor layer 11 in the third opening 52a formed in the second insulating film 52. When the third opening 52a is located on the lateral surface 10c of the semiconductor structure 10, the first wiring 61 is electrically connected to the first semiconductor layer 11 on the lateral surface 10c. In the second opening 20b formed in the first insulating film 20, the second connecting portion 61b of the first wiring 61 is electrically connected to the first portion 31a of the first electrode 31. The intermediate portion 61c of the first wiring 61 connecting the first connecting portion 61a and the second connecting portion 61b is formed on the second insulating film 52 covering the lateral surface 100b of the light-emitting portion 100. The intermediate portion 61c is in contact with the second insulating film 52.

### Step of Forming Third Insulating Film

After forming the first wiring 61, as illustrated in FIG. 14, the method for manufacturing the light-emitting element according to the first embodiment may include a step of forming the third insulating film 53 covering the first wiring 61. The third insulating film 53 may be formed, for example, by the CVD method or sputtering method.

### Step of Separating Light-emitting Portion and Second Substrate

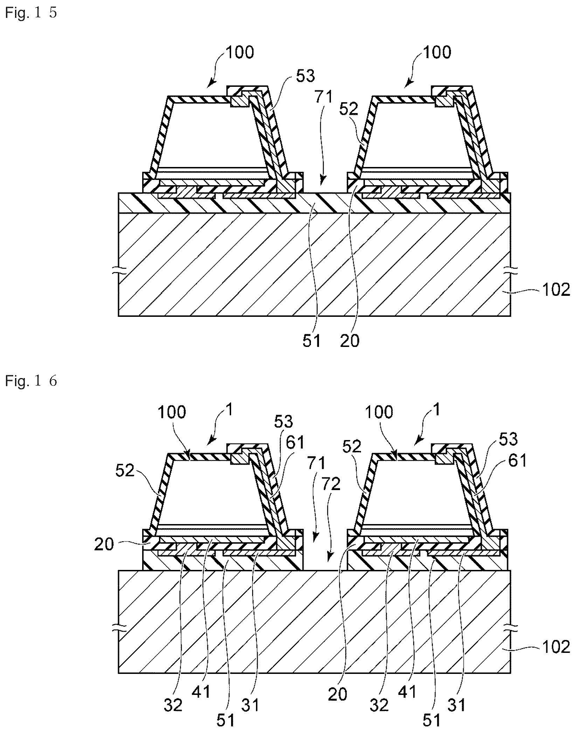

After the first wiring 61 is formed, the light-emitting portion 100 and the second substrate 102 are separated from each other. The step of separating the light-emitting portion 100 and the second substrate 102 can include the steps illustrated in FIGS. 15 to 17.

After the first wiring 61 is formed, a first groove 71 illustrated in FIG. 15 is formed in the first insulating film 20 by removing the first insulating film 20 located in the region between the light-emitting portions 100 in a plan view. In the first groove 71, the upper surface of the bonding member 51 is exposed from the second insulating film 52 and the first insulating film 20. In a case in which the second insulating film 52 is also disposed in the region between the light-emitting portions 100 in a plan view, the first insulating film 20 is removed after the second insulating film 52 is removed. The second insulating film 52 can be removed by a method that is the same as or similar to the method for removing the first insulating film 20.

After the first groove 71 is formed, in the step illustrated in FIG. 16, the bonding member 51 below the first groove 71 is removed to form a second groove 72 below the first groove 71. A plurality of light-emitting elements 1 separated from each other by the first groove 71 and the second groove 72 on the second substrate 102 are obtained. Each of the light-emitting elements 1 includes the light-emitting portion 100, the first electrode 31, the second electrode 32, the first insulating film 20, the second insulating film 52, and the first wiring 61. The light-emitting element 1 may include the conductive layer 41 and the third insulating film 53 as necessary.

The first groove 71 and the second groove 72 can be formed by the RIE method, for example. After the first groove 71 is formed by the RIE method, the type of gas is changed, and the second groove 72 can be formed by the RIE method. The first groove 71 can be formed by the RIE method using a gas containing fluorine, for example. The second groove 72 can be formed by the RIE method using a gas containing oxygen, for example. The first groove 71 and the second groove 72 may be successively formed by the RIE method using the same gas.

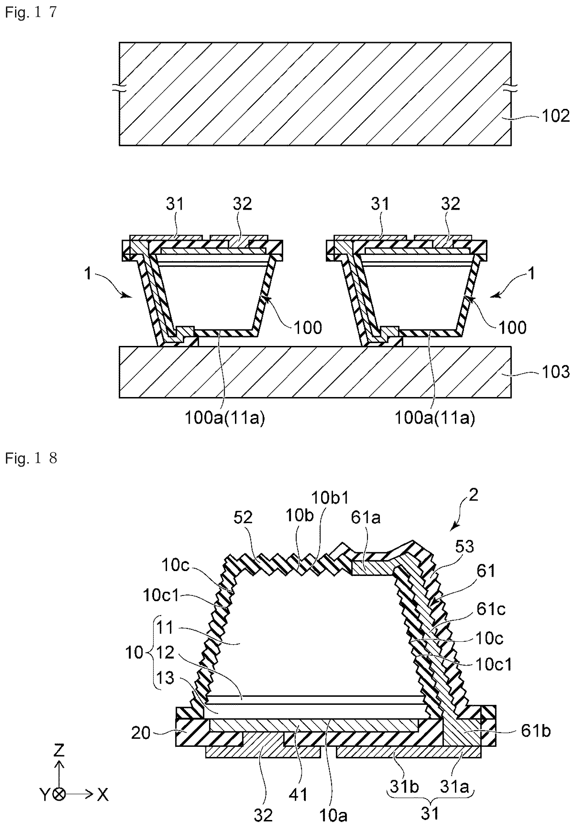

The light-emitting element 1 is supported on the second substrate 102 via the bonding member 51. For example, the light-emitting element 1 and the second substrate 102 can be separated by irradiating the bonding member 51 with laser light from the second substrate 102 side to remove the bonding member 51. As illustrated in FIG. 17, the upper surface 100a side of the light-emitting portion 100 in the light-emitting element 1 separated from the second substrate 102 is bonded to, for example, a support member 103 having adhesiveness. The light-emitting element 1 may be separated from the second substrate 102 after being bonded to the support member 103. In a case in which the bonding member 51 remains on the first electrode 31 and the second electrode 32 after the light-emitting element 1 is separated from the second substrate 102, the bonding member 51 may be removed by the RIE method to expose the first electrode 31 and the second electrode 32. The first electrode 31 and the second electrode 32 serve as external connection terminals to be bonded to the conductive portion of the wiring substrate.

In the step of separating the semiconductor structure 10 into the plurality of light-emitting portions 100, as illustrated in FIG. 10, the semiconductor structure 10 can be separated into the plurality of light-emitting portions 100 so that the first electrode 31 includes the second portion 31b located inward of the outer edge 100d of the light-emitting portion 100 in a plan view. This can allow the area of the first electrode 31 to be increased while reducing the size of the light-emitting element. As described above, increasing the area of the first electrode 31 can reduce the forward voltage, and enhance the heat dissipation effect when the light-emitting element is disposed on the wiring substrate.

In a plan view, the area of the first portion 31a is preferably less than the area of the second portion 31b. Accordingly, the size of the light-emitting element can be reduced. In addition, the area of the second portion 31b is greater than the area of the first portion 31a in a plan view, so that the ease of disposing the light-emitting element on the wiring substrate, the effect of reducing the forward voltage, and the heat dissipation effect, which have been described above, can be enhanced.

In the step of forming the first wiring 61, the first wiring 61 is preferably formed of a light-transmissive conductive film. This can reduce absorption of light by the first wiring 61 when the light is emitted from the active layer 12.

### Second Embodiment

FIG. 18 is a schematic cross-sectional view of a light-emitting element 2 according to a second embodiment.

In the light-emitting element 2 according to the second embodiment, the first surface 10b of the semiconductor structure 10 includes a plurality of protruding portions 10b1, and the lateral surface 10c of the semiconductor structure 10 includes a plurality of protruding portions 10c1. This can enhance the efficiency of light extraction from the first surface 10b and the lateral surface 10c.

The arithmetic average height of the first surface 10b including the plurality of protruding portions 10b1 can be greater than the arithmetic average height of the lateral surface 10c including the plurality of protruding portions 10c1. Accordingly, light is more easily extracted from the first surface 10b than from the lateral surface 10c, and light distribution characteristics having high directivity in the direction directly above the first surface 10b can be obtained.

Further, protruding portions having a shape conforming to the protruding portions 10b1 are formed on the surface of the second insulating film 52 covering the first surface 10b. Protruding portions having a shape conforming to the protruding portions 10c1 of the lateral surface 10c are formed on the surface of the second insulating film 52 covering the lateral surface 10c. This can enhance the extraction efficiency of light to be extracted from the first surface 10b and the lateral surface 10c via the second insulating film 52. Further, protruding portions having a shape conforming to the protruding portions 10c1 are formed on the surface of the first wiring 61 disposed on the second insulating film 52 covering the lateral surface 10c, and formed on the surface of the third insulating film 53 covering the first wiring 61. This can enhance the extraction efficiency of light to be extracted from the lateral surface 10c via the first wiring 61 and the third insulating film 53.

A first method for forming a plurality of protruding portions on the first surface 10b and the lateral surface 10c of the semiconductor structure 10 in the light-emitting element 2 will be described with reference to FIGS. 8, 19, and 20.

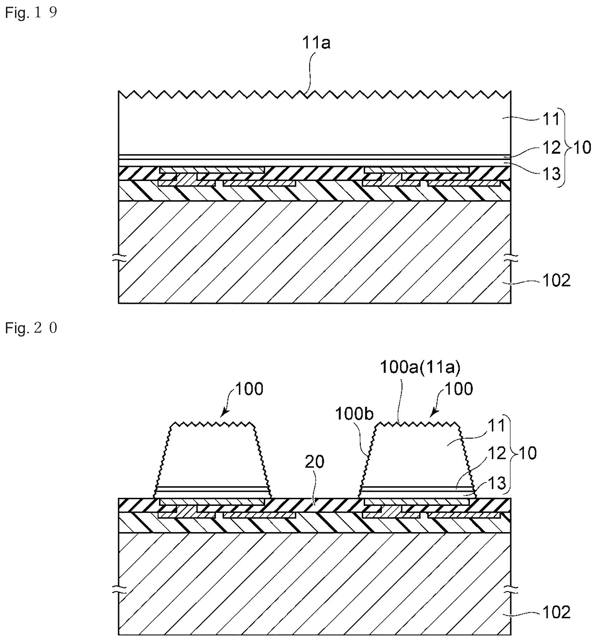

In the first method, after the step of exposing the upper surface 11a of the first semiconductor layer 11 illustrated in FIG. 8, the upper surface 11a of the first semiconductor layer 11 is roughened before the semiconductor structure 10 is separated into the plurality of light-emitting portions 100 as illustrated in FIG. 19. For example, the upper surface 11a of the first semiconductor layer 11 may be roughened by wet etching using an alkaline solution such as tetramethylammonium hydroxide (TMAH), or by dry etching using a gas containing chlorine such as Cl₂ or SiCl₄.

After the upper surface 11a of the first semiconductor layer 11 is roughened, as illustrated in FIG. 20, a portion of the semiconductor structure 10 is removed, and the semiconductor structure 10 is separated into the plurality of light-emitting portions 100. For example, a portion of the semiconductor structure 10 is removed by dry etching using a mask disposed on the upper surface 11a of the first semiconductor layer 11. Examples of dry etching include the RIE method. In the RIE method, for example, a gas containing chlorine such as Cl₂ or SiCl₄ can be used. Dry etching has good etching controllability, and the light-emitting portions 100 after etching can be easily formed into a desired shape.

In the step of removing a portion of the semiconductor structure 10 and separating the semiconductor structure 10 into the light-emitting portions 100, the dry etching proceeds from the roughened upper surface 11a of the first semiconductor layer 11 exposed from the mask. Thus, the dry-etched surface of the semiconductor structure 10 has a greater roughness than in a case in which the upper surface 11a is not roughened in advance. Accordingly, as illustrated in FIG. 20, the lateral surface 100b of the light-emitting portions 100 exposed by removing a portion of the semiconductor structure 10 can be roughened. This can allow the step of separating the semiconductor structure 10 into the plurality of light-emitting portions 100, and the step of roughening the lateral surface 100b of the light-emitting portions 100 to be performed in a single step, allowing a light-emitting element with enhanced light extraction efficiency to be efficiently manufactured. The lateral surface 100b of the light-emitting portion 100 exposed by removing a portion of the semiconductor structure 10 illustrated in FIG. 20 corresponds to the lateral surface 10c of the semiconductor structure 10 in the light-emitting element 2 illustrated in FIG. 18.

Alternatively, the semiconductor structure 10 may be partially removed by wet etching to be separated into the light-emitting portions 100. Wet etching is more likely to increase the roughness of the lateral surface 10c and enhance the extraction efficiency of light from the lateral surface 10c compared to dry etching.

A second method for forming a plurality of protruding portions on the first surface 10b and the lateral surface 10c of the semiconductor structure 10 in the light-emitting element 2 will be described with reference to FIGS. 9 and 20.

According to the second method, after the step of separating the semiconductor structure 10 into the plurality of light-emitting portions 100 as illustrated in FIG. 9, the upper surface 100a and the lateral surface 100b of the light-emitting portions 100 are roughened as illustrated in FIG. 20.

For example, the upper surface 100a and the lateral surface 100b of the light-emitting portions 100 are roughened by dry etching using a gas containing chlorine or wet etching using an alkaline solution such as TMAH. According to the second method, the upper surface 100a and the lateral surface 100b of the light-emitting portions 100 can be roughened in a single step, and thus a light-emitting element with enhanced light extraction efficiency can be efficiently manufactured. The upper surface 100a and the lateral surface 100b of the light-emitting portions 100 in FIG. 20 correspond respectively to the first surface 10b and the lateral surface 10c of the semiconductor structure 10 in the light-emitting element 2 illustrated in FIG. 18.

According to the second method, a portion of the semiconductor structure 10 is removed in a state in which the upper surface 11a of the first semiconductor layer 11 is not roughened, and the semiconductor structure 10 is separated into the plurality of light-emitting portions 100. According to the second method, the upper surface 11a of the first semiconductor layer 11, which corresponds to the first surface 100a of the light-emitting portion 100, is etched in a state in which the upper surface 11a has high flatness, and thus, it is easy to form the light-emitting portion 100 into a desired shape, compared to the first method.

In addition, in a case in which the first substrate 101 is a sapphire substrate and the first semiconductor structure 10 is grown on the C-plane of the sapphire substrate, the upper surface 100a of the light-emitting portion 100 and the lateral surface 100b of the light-emitting portion 100 have different crystallographic orientations. Thus, after separation into the light-emitting portions 100, the roughening step is performed on the upper surface 100a of the light-emitting portions 100 and the lateral surface 100b of the light-emitting portions 100, so that the upper surface 100a of the light-emitting portions 100 can have a greater surface roughness than the lateral surface 100b of the light-emitting portions 100. Accordingly, light is more easily extracted from the first surface 10b than from the lateral surface 10c of the semiconductor structure 10 in the light-emitting element 2, and light distribution characteristics having high directivity in the direction directly above the first surface 10b can be obtained.

### Third Embodiment

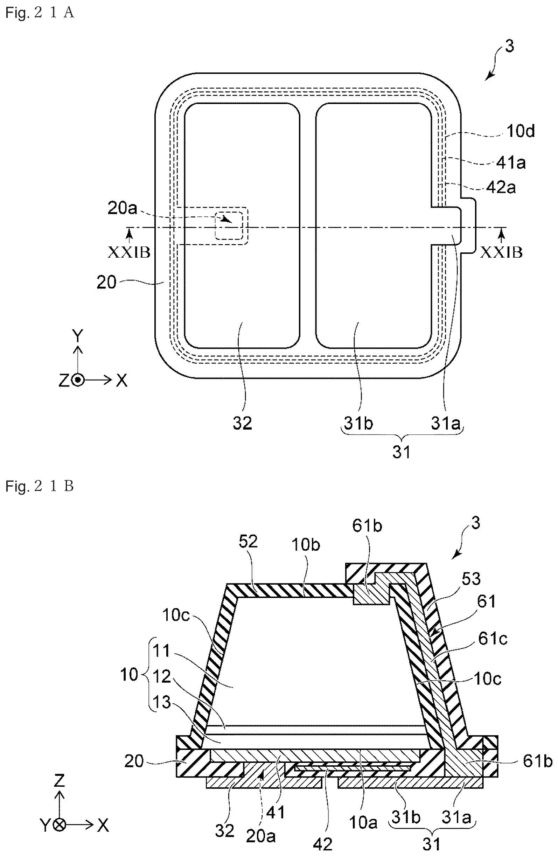

FIG. 21A is a schematic bottom view of a light-emitting element 3 according to the third embodiment. FIG. 21B is a schematic cross-sectional view taken along the line XXIB-XXIB of FIG. 21A.

The light-emitting element 3 according to the third embodiment further includes a reflective film 42 disposed between the second semiconductor layer 13 and the second electrode 32. The reflective film 42 has light reflectivity to light emitted from the active layer 12. A metal can be used as the material of the reflective film 42, for example. The reflective film 42 can include, for example, an Al film, a Ti film, or a multilayer structure thereof. The light traveling from the active layer 12 toward the second surface 10a side of the semiconductor structure 10 can be reflected by the reflective film 42, and directed toward the first surface 10b and the lateral surface 10c. This configuration can enhance the brightness of the light-emitting element 3. The reflectance of the reflective film 42 to the peak wavelength of light emitted from the active layer 12 is, for example, 60% or greater and preferably 70% or greater.

The reflective film 42 can be disposed, for example, between the conductive layer 41 and the second portion 31b. The first insulating film 20 is positioned between the reflective film 42 and the conductive layer 41, between the reflective film 42 and the second electrode 32, and between the reflective film 42 and the second portion 31b of the first electrode 31.

As illustrated in FIG. 21A, in a plan view, an outer edge 42a of the reflective film 42 can be located inward of an outer edge 41a of the conductive layer 41, for example. In a plan view, the reflective film 42 does not overlap the portion where the second electrode 32 connects to the conductive layer 41 in the first opening 20a of the first insulating film 20.

In a plan view, the reflective film 42 is preferably disposed at a position overlapping a region between the first electrode 31 and the second electrode 32. The reflective film 42 is disposed in this manner, so that light from the active layer 12, which travels toward the second surface 10a side can be reflected toward the first surface 10b in the region between the first electrode 31 and the second electrode 32. This enhances the light extraction efficiency in the light-emitting element 3. In addition, in a plan view, the area of the reflective film 42 can be set to a range of 60% to 90% of the area of the second surface 10a. As a result, the light extraction efficiency in the light-emitting element 3 can be enhanced.

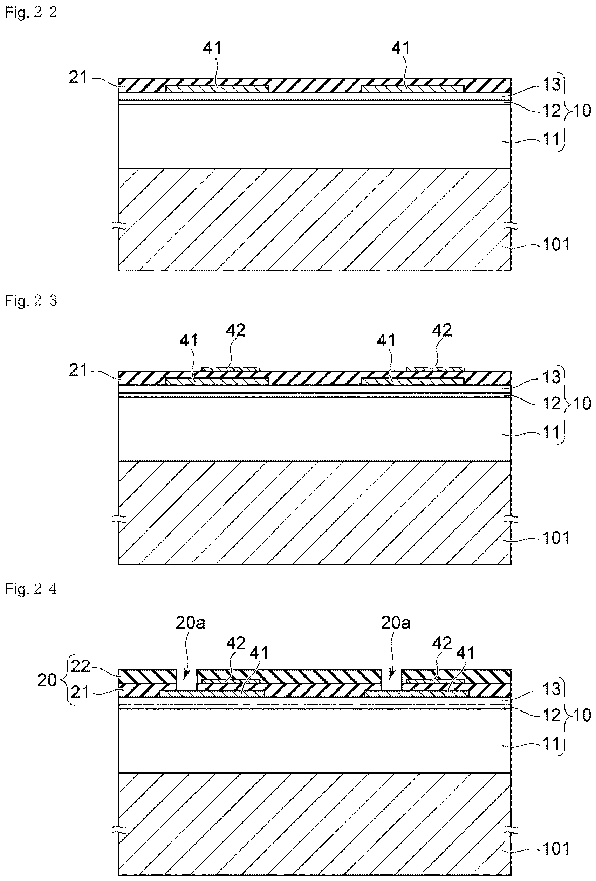

The step of preparing a wafer in the method for manufacturing the light-emitting element 3 according to the third embodiment can include the steps illustrated in FIGS. 22 to 25.

As illustrated in FIG. 22, a first layer 21 of the first insulating film 20 is formed on the upper surface of the second semiconductor layer 13 formed on the conductive layer 41 disposed on the upper surface of the second semiconductor layer 13.

After the first layer 21 is formed, the reflective film 42 is formed on the first layer 21 as illustrated in FIG. 23. The reflective film 42 can be formed by the sputtering method or vapor deposition method, for example.

After the reflective film 42 is formed, as illustrated in FIG. 24, a second layer 22 of the first insulating film 20 is formed on the first layer 21 so as to cover the reflective film 42. After forming the second layer 22, the first openings 20a are formed in the first insulating film 20. The first openings 20a are formed in a portion where the reflective film 42 is not disposed above the conductive layer 41.

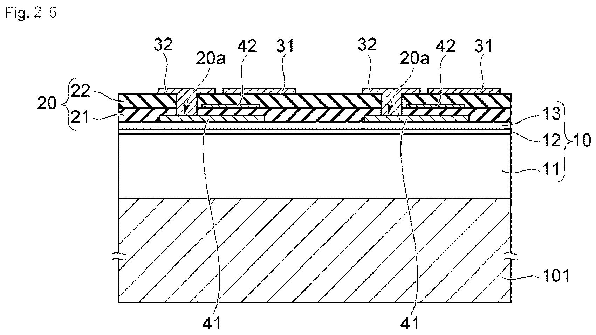

After the first openings 20a are formed, as illustrated in FIG. 25, the second electrodes 32 are formed in the first openings 20a and on the second layer 22. The first electrodes 31 are formed on the second layer 22.

The structure of the light-emitting element 2 in the second embodiment, and the structure of the light-emitting element 3 in the third embodiment may be combined to form a light-emitting element including the reflective film 42 and the semiconductor structure 10 including the roughened first surface 10b and the roughened lateral surface 10c.

The embodiments according to the present invention include the following method for manufacturing a light-emitting element and a light-emitting element.

### [Clause 1]

A method for manufacturing a light-emitting element, comprising:
a step of preparing a wafer comprising,
   a first substrate,
   a semiconductor structure disposed on the first substrate and comprising,
      a first semiconductor layer,
      a second semiconductor layer farther from the first substrate than the first semiconductor layer, and
      an active layer located between the first semiconductor layer and the second semiconductor layer,
   a first insulating film disposed on the second semiconductor layer and having an opening located above the second semiconductor layer;
   a plurality of first electrodes disposed on the first insulating film; and
   a plurality of second electrodes spaced apart from the first electrodes on the first insulating film, and electrically connected to the second semiconductor layer in the opening;
a step of bonding a side of the wafer where the second electrodes and the first electrodes are disposed, to a second substrate;
a step of exposing an upper surface of the first semiconductor layer by removing the first substrate after the bonding of the wafer to the second substrate;
a step of removing a portion of the semiconductor structure from a upper surface side of the first semiconductor layer to separate the semiconductor structure into a plurality of light-emitting portions in such a manner that the first electrode comprises a first portion located outward of an outer edge of each of the light-emitting portions in a plan view;
a step of forming a second insulating film covering the light-emitting portions;
a step of exposing the first portion of each of the first electrodes from the first insulating film and exposing a portion of the first semiconductor layer of each of the light-emitting portions from the second insulating film, wherein
   the exposing of the first portion of each of the first electrodes from the first insulating film is performed by removing a portion of the first insulating film, and
   the exposing of the portion of the first semiconductor layer of each of the light-emitting portions from the second insulating film by removing the portion of the second insulating film;
a step of forming a first wiring on the second insulating film with respect to each of the light-emitting portions, the first wiring electrically connecting the portion of the first semiconductor layer exposed from the second insulating film and the first portion of the first electrode exposed from the first insulating film; and
a step of separating the light-emitting portions and the second substrate after the first wiring is formed.

### [Clause 2]

The method for manufacturing a light-emitting element according to clause 1, wherein in the step of separating the semiconductor structure into the plurality of light-emitting portions, the semiconductor structure is separated into the plurality of light-emitting portions in such a manner that the first electrode comprises a second portion located inward of the outer edge of each of the light-emitting portions in the plan view.

### [Clause 3]

The method for manufacturing a light-emitting element according to clause 2, wherein an area of the first portion is less than an area of the second portion in the plan view.

### [Clause 4]

The method for manufacturing a light-emitting element according to any one of clauses 1 to 3, further comprising
after the step of exposing the upper surface of the first semiconductor layer, roughening the upper surface of the first semiconductor layer.

### [Clause 5]

The method for manufacturing a light-emitting element according to any one of clauses 1 to 3, further comprising
after the step of separating the semiconductor structure into the plurality of light-emitting portions, roughening an upper surface and a lateral surface of each of the light-emitting portions.

### [Clause 6]

The method for manufacturing a light-emitting element according to any one of clauses 1 to 3, wherein
in the step of forming the first wiring, the first wiring is formed of a light-transmissive conductive film.

### [Clause 7]

The method for manufacturing a light-emitting element according to any one of clauses 1 to 3, wherein
in the step of preparing the wafer, the wafer further comprising a conductive layer is prepared, the conductive layer being disposed on the second semiconductor layer and electrically connected to the second electrode.

### [Clause 8]

The method for manufacturing a light-emitting element according to clause 7, wherein
in the step of preparing the wafer, the wafer further comprising a reflective film is prepared, the reflective film being disposed between the conductive layer and the second electrode.

### [Clause 9]

The method for manufacturing a light-emitting element according to clause 8, wherein
an area of the reflective film is in a range of 60% to 90% of an area of the conductive layer in the plan view.

### [Clause 10]

A light-emitting element comprising:
a semiconductor structure having a first surface, a second surface located opposite the first surface, and a lateral surface connecting the first surface and the second surface, the semiconductor structure comprising a first semiconductor layer located closer to the first surface, a second semiconductor layer located closer to the second surface, and an active layer located between the first semiconductor layer and the second semiconductor layer;
a first insulating film disposed on the second surface and having an opening disposed at a position overlapping the second surface in a plan view;
a first electrode disposed on the first insulating film and not connecting to the second surface, the first electrode comprising a first portion located outward of an outer edge of the semiconductor structure in the plan view;
a second electrode spaced apart from the first electrode on the first insulating film, and electrically connected to the second semiconductor layer in the opening on the second surface;
a second insulating film disposed on the first surface and the lateral surface of the semiconductor structure; and
a first wiring disposed on the second insulating film, and electrically connecting a portion of the first semiconductor layer exposed from the second insulating film and the first portion of the first electrode exposed from the first insulating film.

### [Clause 11]

The light-emitting element according to clause 10, wherein
the first electrode comprises a second portion located inward of the outer edge of the semiconductor structure in the plan view.

### [Clause 12]

The light-emitting element according to clause 11, wherein
an area of the first portion is less than an area of the second portion in the plan view.

### [Clause 13]

The light-emitting element according to any one of clauses 10 to 12, wherein
the first surface and the lateral surface of the semiconductor structure both comprise a plurality of protruding portions.

### [Clause 14]

The light-emitting element according to clause 13, wherein
an arithmetic average height of the first surface of the semiconductor structure comprising the plurality of protruding portions is greater than an arithmetic average height of the lateral surface of the semiconductor structure comprising the plurality of protruding portions.

### [Clause 15]

The light-emitting element according to any one of clauses 10 to 12, wherein
the first wiring is formed of a light-transmissive conductive film.

### [Clause 16]

The light-emitting element according to any one of clauses 10 to 12, further comprising:
a conductive layer disposed on the second surface of the semiconductor structure, and electrically connected to the second semiconductor layer and the second electrode.

### [Clause 17]

The light-emitting element according to clause 16, further comprising:
a reflective film disposed between the conductive layer and the second electrode.

### [Clause 18]

The light-emitting element according to clause 17, wherein
an area of the reflective film is in a range of 60% to 90% of an area of the conductive layer in the plan view.

The embodiments of the present invention have been described above with reference to specific examples. However, the present invention is not limited to these specific examples. All aspects that can be practiced by a person skilled in the art changing the design as appropriate based on the above-described embodiments of the present invention are also included in the scope of the present invention, as long as they encompass the spirit of the present invention. In addition, in the spirit of the present invention, a person skilled in the art can conceive of various modified examples and altered examples, and those modified examples and altered examples will also fall within the scope of the present invention.

### Reference Signs List

- 1 to 3.: Light-emitting element,
- 10.: Semiconductor structure,
- 10a.: Second surface,
- 10b.: First surface,
- 10c.: Lateral surface,
- 10d.: Outer edge,
- 11.: First semiconductor layer,
- 12.: Active layer,
- 13.: Second semiconductor layer,
- 20.: First insulating film,
- 20a.: First opening,
- 20b.: Second opening,
- 21.: First layer,
- 22.: Second layer,
- 31.: First electrode,
- 31a.: First portion,
- 31b.: Second portion,
- 32.: Second electrode,
- 41.: Conductive layer,
- 42.: Reflective film,
- 51.: Bonding member,
- 52.: Second insulating film,
- 52a.: Third opening,
- 52b: Fourth opening,
- 53.: Third insulating film,
- 61.: First wiring,
- 100.: Light-emitting portion,
- 100d.: Outer edge,
- 101.: First substrate,
- 102.: Second substrate,
- W.: Wafer

## Claims

1. A method for manufacturing a light-emitting element, comprising:
a step of preparing a wafer comprising,
a first substrate,
a semiconductor structure disposed on the first substrate and comprising,
a first semiconductor layer,
a second semiconductor layer farther from the first substrate than the first semiconductor layer, and
an active layer located between the first semiconductor layer and the second semiconductor layer,
a first insulating film disposed on the second semiconductor layer and having an opening located above the second semiconductor layer;
a plurality of first electrodes disposed on the first insulating film; and
a plurality of second electrodes spaced apart from the first electrodes on the first insulating film, and electrically connected to the second semiconductor layer in the opening;
a step of bonding a side of the wafer where the second electrodes and the first electrodes are disposed, to a second substrate;
a step of exposing an upper surface of the first semiconductor layer by removing the first substrate after the bonding of the wafer to the second substrate;
a step of removing a portion of the semiconductor structure from a upper surface side of the first semiconductor layer to separate the semiconductor structure into a plurality of light-emitting portions in such a manner that the first electrode comprises a first portion located outward of an outer edge of each of the light-emitting portions in a plan view;
a step of forming a second insulating film covering the light-emitting portions;
a step of exposing the first portion of each of the first electrodes from the first insulating film and exposing a portion of the first semiconductor layer of each of the light-emitting portions from the second insulating film, wherein
the exposing of the first portion of each of the first electrodes from the first insulating film is performed by removing a portion of the first insulating film, and
the exposing of the portion of the first semiconductor layer of each of the light-emitting portions from the second insulating film by removing the portion of the second insulating film;
a step of forming a first wiring on the second insulating film with respect to each of the light-emitting portions, the first wiring electrically connecting the portion of the first semiconductor layer exposed from the second insulating film and the first portion of the first electrode exposed from the first insulating film; and
a step of separating the light-emitting portions and the second substrate after the first wiring is formed.

2. The method for manufacturing a light-emitting element according to claim 1, wherein
in the step of separating the semiconductor structure into the plurality of light-emitting portions, the semiconductor structure is separated into the plurality of light-emitting portions in such a manner that the first electrode comprises a second portion located inward of the outer edge of each of the light-emitting portions in the plan view.

3. The method for manufacturing a light-emitting element according to claim 2, wherein
an area of the first portion is less than an area of the second portion in the plan view.

4. The method for manufacturing a light-emitting element according to any one of claims 1 to 3, further comprising
after the step of exposing the upper surface of the first semiconductor layer, roughening the upper surface of the first semiconductor layer.

5. The method for manufacturing a light-emitting element according to any one of claims 1 to 3, further comprising
after the step of separating the semiconductor structure into the plurality of light-emitting portions, roughening an upper surface and a lateral surface of each of the light-emitting portions.

6. The method for manufacturing a light-emitting element according to any one of claims 1 to 3, wherein
in the step of forming the first wiring, the first wiring is formed of a light-transmissive conductive film.

7. The method for manufacturing a light-emitting element according to any one of claims 1 to 3, wherein
in the step of preparing the wafer, the wafer further comprising a conductive layer is prepared, the conductive layer being disposed on the second semiconductor layer and electrically connected to the second electrode.

8. The method for manufacturing a light-emitting element according to claim 7, wherein
in the step of preparing the wafer, the wafer further comprising a reflective film is prepared, the reflective film being disposed between the conductive layer and the second electrode.

9. The method for manufacturing a light-emitting element according to claim 8, wherein
an area of the reflective film is in a range of 60% to 90% of an area of the conductive layer in the plan view.

10. A light-emitting element comprising:
a semiconductor structure having a first surface, a second surface located opposite the first surface, and a lateral surface connecting the first surface and the second surface, the semiconductor structure comprising a first semiconductor layer located closer to the first surface, a second semiconductor layer located closer to the second surface, and an active layer located between the first semiconductor layer and the second semiconductor layer;
a first insulating film disposed on the second surface and having an opening disposed at a position overlapping the second surface in a plan view;
a first electrode disposed on the first insulating film and not connecting to the second surface, the first electrode comprising a first portion located outward of an outer edge of the semiconductor structure in the plan view;
a second electrode spaced apart from the first electrode on the first insulating film, and electrically connected to the second semiconductor layer in the opening on the second surface;
a second insulating film disposed on the first surface and the lateral surface of the semiconductor structure; and
a first wiring disposed on the second insulating film, and electrically connecting a portion of the first semiconductor layer exposed from the second insulating film and the first portion of the first electrode exposed from the first insulating film.

11. The light-emitting element according to claim 10, wherein
the first electrode comprises a second portion located inward of the outer edge of the semiconductor structure in the plan view.

12. The light-emitting element according to claim 11, wherein
an area of the first portion is less than an area of the second portion in the plan view.

13. The light-emitting element according to any one of claims 10 to 12, wherein
the first surface and the lateral surface of the semiconductor structure both comprise a plurality of protruding portions.

14. The light-emitting element according to claim 13, wherein
an arithmetic average height of the first surface of the semiconductor structure comprising the plurality of protruding portions is greater than an arithmetic average height of the lateral surface of the semiconductor structure comprising the plurality of protruding portions.

15. The light-emitting element according to any one of claims 10 to 12, wherein
the first wiring is formed of a light-transmissive conductive film.

16. The light-emitting element according to any one of claims 10 to 12, further comprising:
a conductive layer disposed on the second surface of the semiconductor structure, and electrically connected to the second semiconductor layer and the second electrode.

17. The light-emitting element according to claim 16, further comprising:
a reflective film disposed between the conductive layer and the second electrode.

18. The light-emitting element according to claim 17, wherein
an area of the reflective film is in a range of 60% to 90% of an area of the conductive layer in the plan view.
